# EUROPEAN PATENT APPLICATION

(11) **EP 2 341 507 A1**
(43) Date of publication of application: **06.07.2011**
(21) Application number: 09823375.2
(22) Date of filing: 27.05.2009
(51) Int. Cl.: G11C 19/28, G09G 3/20, G09G 3/36, G11C 19/00

(54) **SHIFT REGISTER CIRCUIT, DISPLAY DEVICE AND SHIFT REGISTER CIRCUIT DRIVING METHOD**

(30) Priority: 30.10.2008 JP 2008280344
(71) Applicant: Sharp Kabushiki Kaisha, Osaka-shi, Osaka 545-8522 (JP)
(72) Inventor: IWAMOTO, Akihisa, Osaka-shi OSAKA 545-8522 (JP); MIZUNAGA, Takayuki, Osaka-shi OSAKA 545-8522 (JP); MORII, Hideki, Osaka-shi OSAKA 545-8522 (JP); OHTA, Yuuki, Osaka-shi OSAKA 545-8522 (JP); IKUTA, Kei, Osaka-shi OSAKA 545-8522 (JP)
(74) Representative: Goddar, Heinz J.
(86) International application number: PCT/JP2009/059721
(87) International publication number: WO 2010/050262

(57) **Abstract**

A control section (1) prepares a control signal and supplies the control signal to a control terminal (netB) of a first switching element (T6), the control signal causing the first switching element (T6) to turn on in accordance with a non-active voltage level of a storage node (netA) and an active voltage level of a second clock signal which active voltage level is obtained in a period in which the second clock signal is active.

## Description

### Technical Field

The present invention relates to a shift register circuit which is monolithically formed on a display panel.

### Background Art

A gate monolithic technology has recently been advanced in which a gate driver is monolithically formed on a liquid crystal panel by use of amorphous silicon so as to achieve a cost reduction. A monolithic gate driver is also referred to as a gate driver-free, a built-in gate driver in panel, a gate in panel, etc.

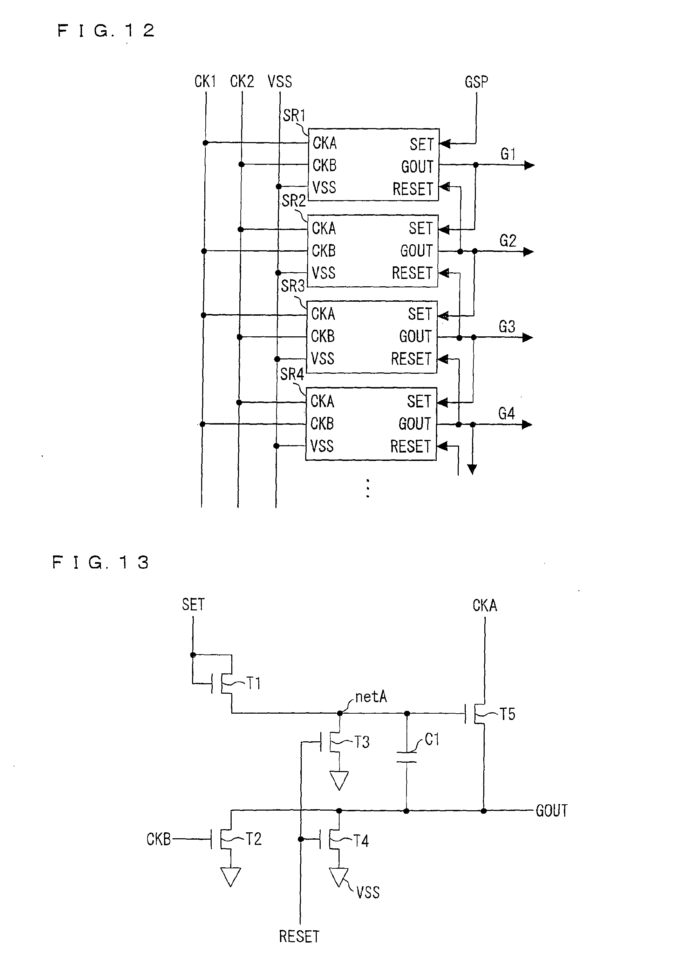

Fig. 12 illustrates an example of a configuration of a shift register circuit constituting a gate driver which is monolithically formed by the gate monolithic technology.

The shift register circuit includes a shift register SRk (k is a natural number) in which a set terminal SET, an output terminal GOUT, a reset terminal RESET, a low supply voltage input terminal VSS, and clock input terminals CKA and CKB are provided. The output signal GOUT (this reference sign is shared between the output terminal and the output signal) of a shift register SRk-1 which is followed by the shift register SRk is inputted via the set terminal SET of the shift register SRk (k ≥ 2). A gate start pulse signal GSP is inputted via the set terminal SET of the shift register SR1. An output signal GK is supplied to a corresponding scanning signal line via the output terminal GOUT of the shift register SR1. The output signal GOUT of a shift register SRk+1 which follows the shift register SRk is inputted via the reset terminal RESET of the shift register SR1. A low supply voltage VSS is applied to the low supply voltage input terminal VSS of the shift register SRk. A clock signal CK1 is inputted via one of the clock input terminal CKA and the clock input terminal CKB, and a clock signal CK2 is inputted via the other of the clock input terminal CKA and the clock input terminal CKB. The clock signal CK1 and the clock signal CK2 are alternately inputted via the clock input terminal CKA and the clock input terminal CKB in any first and second shift registers in which the first shift register is followed by the second shift register.

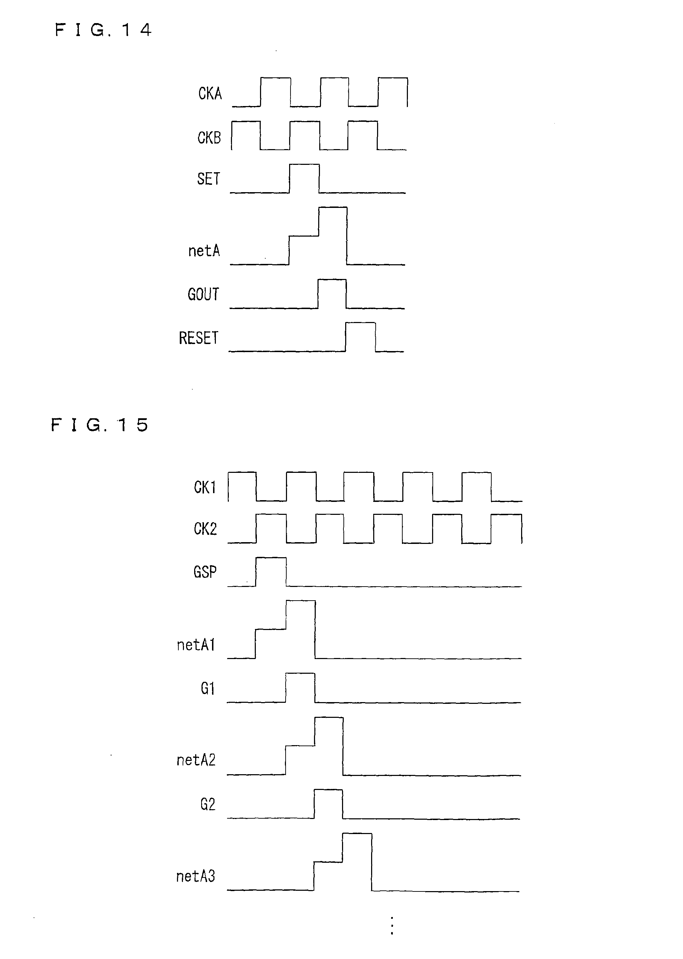

The clock signal CK1 and the clock signal CK2 have a complementary phase relationship in which a period in which one of the clock signal CK1 and the clock signal CK2 is active (high) and a period in which the other of the clock signal CK1 and the clock signal CK2 is active (high) alternate with each other (see Fig. 15). A high level voltage during which the clock signal CK1 and the clock signal CK2 are active is VGH, and a low level voltage during which the clock signal CK1 and the clock signal CK2 are non-active is VGL. The low supply voltage VSS is equivalent to the low level voltage VGL during which the clock signal CK1 and the clock signal CK2 are non-active. In this example, the clock signal CK1 and the clock signal CK2 have a relationship in which their phases are reverse to each other. However, the clock signal CK1 and the clock signal CK2 can also have a relationship in which one of the clock signal CK1 and the clock signal CK2 is active in a period in which the other of the clock signal CK1 and the clock signal CK2 is non-active.

Fig. 13 illustrates an example of a configuration of each of shift registers SRk of the shift register circuit of Fig. 12.

Each of the shift registers SRk includes five transistors T1, T2, T3, T4, and T5, and a capacitor C1. These transistors are all n-channel TFTs.

The transistor T1 has a gate and a drain each of which is connected to the set terminal SET and a source which is connected to a gate of the transistor T5. The transistor T5, which is an output transistor in each of the shift registers SRk, has a drain which is connected to the clock input terminal CKA and a source which is connected to the output terminal GOUT. Namely, the transistor T5 is provided so as to transmit or so as not to transmit, to the output terminal GOUT, the clock signal inputted via the clock input terminal CKA. The capacitor C1 is connected between the gate and the source of the transistor T5. A node whose voltage is equivalent to that of the gate of the transistor T5 is referred to as a node netA.

The transistor T3 has a gate which is connected to the reset terminal RESET, a drain which is connected to the node netA, and a source which is connected to the low supply voltage input terminal VSS. The transistor T4 has a gate which is connected to the reset terminal RESET, a drain which is connected to the output terminal GOUT, and a source which is connected to the low supply voltage input terminal VSS.

The transistor T2 has a gate which is connected to the clock input terminal CKB, a drain which is connected to the output terminal GOUT, and a source which is connected to the low supply voltage input terminal VSS.

Next, operation of each of the shift registers SRk is to be described with reference to Fig. 14.

Before a shift pulse signal is inputted via the set terminal SET, each of the transistors T4 and T5 is in a high impedance state, the transistor T2 turns on every time a clock signal inputted via the clock input terminal CKB is at a high level, and the output terminal GOUT is at a low level. After a gate pulse signal of the output signal GOUT of a shift register SRk-1 which gate pulse signal is the shift pulse signal is inputted via the set terminal SET, an output pulse signal is prepared in a shift register SRk and the transistor T1 turns on so as to charge the capacitor C1. The charge of the capacitor C1 raises the voltage of the node netA to (VGH - Vth) in a case where VGH represents a high level of the gate pulse signal and Vth represents a threshold voltage of the transistor T1. This causes the transistor T5 to turn on, so that the clock signal inputted via the clock input terminal CKA reaches the source of the transistor T5. The transistor T5 obtains a large overdrive voltage since a bootstrap effect of the capacitor C1 boosts the voltage of the node netA the moment a high level clock pulse signal is inputted via the clock input terminal CKA. This causes a high voltage level VGH of the inputted clock pulse signal to be transmitted to and outputted via the output terminal GOUT of the shift register SRk and consequently to be a gate pulse signal Gk (a pulse signal of the output signal GOUT).

An end of the input of the gate pulse signal via the set terminal SET causes the transistor T1 to turn off. In order to discharge an electric charge due to the node netA and the output terminal GOUT of a shift register SRk which are floating, a gate pulse signal Gk+1 of a shift register SRk+1 which gate pulse signal is inputted as a reset pulse signal via the reset terminal RESET causes each of the transistors T3 and T4 to turn on, so as to connect each of the node netA and the output terminal GOUT to the low supply voltage VSS. This causes the transistor T5 to turn off. An end of the input of the reset pulse signal ends the period in which the output pulse signal is prepared in the shift register SRk. The period is followed by a period in which the output terminal GOUT is at a low level again.

As described earlier, gate pulse signals Gk are successively outputted to respective gate lines (see Fig. 15).

The shift resister circuit is configured such that each of the transistors T4 and T5 is in the high impedance state in the period in which the output terminal GOUT is at a low level, so as to cause the output terminal GOUT to be floating. Accordingly, in order to avoid a situation in which the output terminal GOUT cannot be at a low level by noise etc. propagated due to, for example, cross coupling of a gate bus line and a source bus line, the transistor T2 carries out so-called sink-down so as to cause the output terminal GOUT to be at the low supply voltage VSS (see Fig. 13). In the period in which the output terminal GOUT is at the low level, the transistor T3 is also in the high impedance state, so as to cause the node netA to be floating. Therefore, in order not to cause a leak in the transistor T5, a transistor for sink-down is provided for connecting, in this period, the node netA to the low supply voltage VSS.

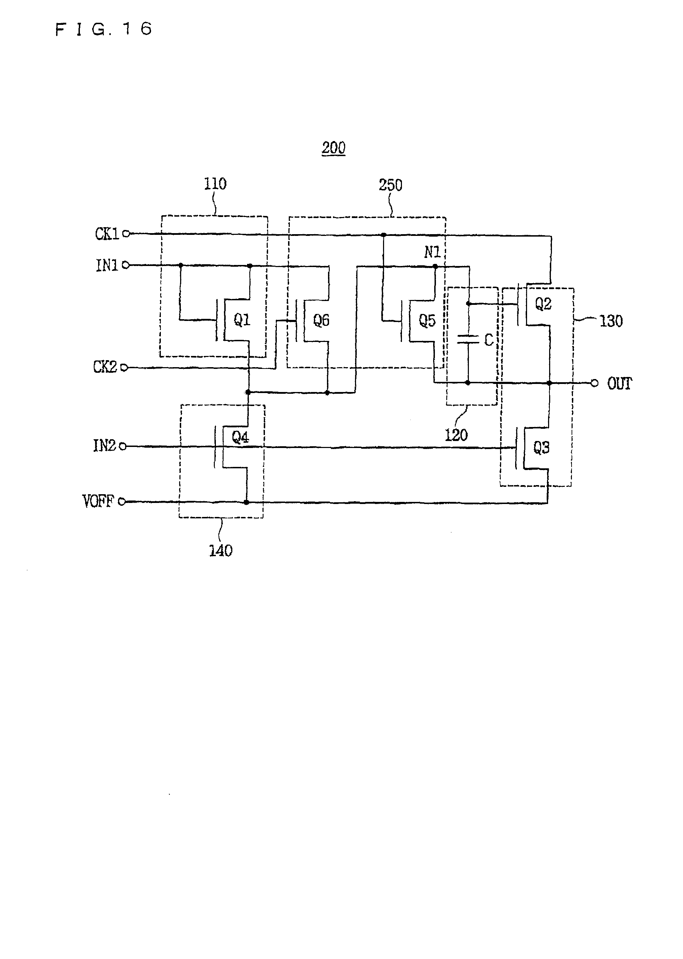

Patent Literature 1 discloses a configuration in which the node netA is subjected to sink-down (see Fig. 16).

According to the configuration, a fifth transistor Q5 and a sixth transistor Q6 are provided so as to prevent a voltage of a first node N1 from changing by an influence of a voltage of a first clock signal CK1 via a parasitic capacitance generated between a gate and a drain of a transistor Q2. The first clock signal CK1 and a second clock signal CK2 have a relationship in which their phases are reverse to each other. The first clock signal CK1 which is at a high level causes the transistor Q5 to turn on, so as to connect the first node N1 to an output terminal OUT. The second clock signal CK2 which is at a high level causes the transistor Q6 to turn on, so as to connect the first node N1 to an input terminal of a first input signal IN1.

Accordingly, in a case where the first input signal IN1 or the output terminal OUT is not at a high level, the first clock signal CK1 which is at a high level causes the fifth transistor Q5 to maintain a voltage of the first node N1 at a first voltage VOFF, and the second clock signal CK2 which is at a high level causes the sixth transistor Q6 to maintain the voltage of the first node N1 at the first voltage VOFF. Patent Literature 1 is directed to prevent the gate of the transistor Q2 from being floating.

### Citation List

### Patent Literature 1

Japanese Patent Application Publication, Tokukai, No. 2005-50502 A (Publication Date: February 24, 2005)

### Summary of Invention

### Technical Problem

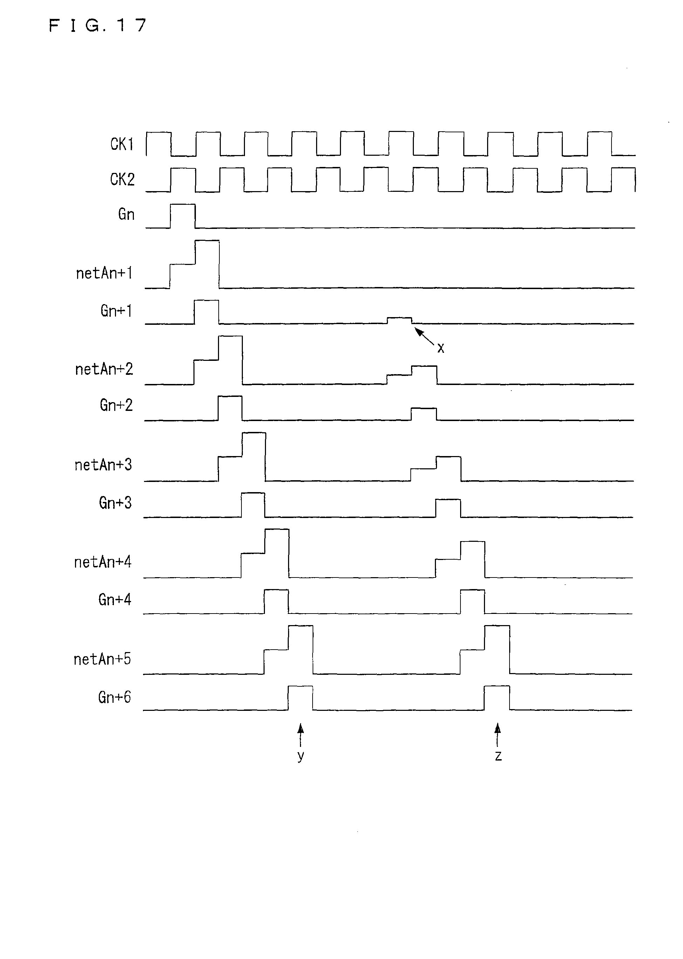

However, according to the configuration of shift registers (see Fig. 13), a leak occurs between the drain and the source of the transistor T5 at a high temperature due to a temperature characteristic of a transistor. Therefore, for example, in a case where the clock signal CK1 which is at a high level leaks into the output terminal GOUT, a voltage of the node netA rises via the capacitor C1 (see x illustrated in Fig. 17). Since a rise in voltage of the node netA causes a larger leak in the transistor T5, such a positive feedback causes a malfunction in a shift register. Such a leak is especially large in a case where a TFT is used as the transistor.

According to the configuration described in Patent Literature 1, the transistor Q5 and the transistor Q6 alternately turn on. Since the first clock signal CK1, which leaks into the output terminal OUT due to a leak between the drain and the source of the transistor Q2, becomes the first input signal IN1 of a following shift register, the voltage of the first node N1 rises when the transistor Q6 of the following shift register turns on. In addition to this, a bootstrap effect of the capacitor C causes a larger leak in the transistor Q5 of the following shift register, so that not only a normal gate output Gk (see y illustrated in Fig. 17) but also an abnormal pulse (see z illustrated in Fig. 17) due to the leak in the transistor Q5 of the following shift register occurs in following registers. This also causes a malfunction in a shift register.

As described earlier, there occurs a problem that a leak in an output switching element which outputs a gate pulse signal causes a malfunction in the conventional shift register.

The present invention has been made in view of the problems, and its object is to realize a shift register circuit which is capable of preventing a malfunction even if a leak occurs in an output switching element of a shift register, a display device including the shift register circuit, and a method for driving the shift register circuit.

### Solution to Problem

In order to attain the object, a shift register circuit of the present invention in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals, the each of the plurality of shift registers includes: an input gate from which an input signal is outputted only in a period in which the input signal is active; a storage node which is charged by the input signal supplied from the input gate; an output switching element, which has (i) a control terminal, connected to the storage node, via which the output switching element is turned on or off, (ii) one end terminal via which the first clock signal is inputted, and (iii) the other end terminal which is connected to an output terminal of the each of the plurality of shift registers; a first switching element connected between the storage node and a voltage supply which supplies a non-active voltage level to the storage node; and a control section which prepares a control signal and supplies the control signal to the control terminal of the first switching element, the control signal causing the first switching element to turn on in accordance with the non-active voltage level of the storage node and an active voltage level of the second clock signal which active voltage level is obtained in a period in which the second clock signal is active, the plurality of shift registers being connected to be cascaded such that in any first and second shift registers, between which shift pulse signals are communicated and in which the first shift register is followed by the second shift resister, an output terminal of the first shift register is connected to an input gate of the second shift register, and the second clock signal of the second shift register being supplied, as the first clock signal of the first shift register, to the first shift register.

According to the invention, even if an abnormal pulse occurs in an input terminal of the second shift register due to a leak in the output switching element of the first shift register, so as to cause the input gate to turn on, the storage node is subjected to sink-down by the first switching element every time the second clock signal of the second shift register which corresponds to the first clock signal of the first shift register is active. This prevents a voltage of the storage node from rising and allows the storage node to be stable at a non-active voltage level (Low, VSS), so that the leak is not transmitted to following shift registers.

This brings about an effect of realizing a shift register circuit which is capable of preventing a malfunction even if a leak occurs in an output switching element of a shift register.

In order to attain the object, a shift register circuit of the present invention in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals, the each of the plurality of shift registers includes: an input gate from which an input signal is outputted only in a period in which the input signal is active; a storage node which is charged by the input signal supplied from the input gate; an output switching element, which has (i) a control terminal, connected to the storage node, via which the output switching element is turned on or off, (ii) one end terminal via which the first clock signal is inputted, and (iii) the other end terminal which is connected to an output terminal of the each of the plurality of shift registers; a first switching element connected between the storage node and the output terminal; and a control section which prepares a control signal and supplies the control signal to the control terminal of the first switching element, the control signal causing the first switching element to turn on in accordance with the non-active voltage level of the storage node and an active voltage level of the second clock signal which active voltage level is obtained in a period in which the second clock signal is active, the plurality of shift registers being connected to be cascaded such that in any first and second shift registers, between which shift pulse signals are communicated and in which the first shift register is followed by the second shift resister, an output terminal of the first shift register is connected to an input gate of the second shift register, and the second clock signal of the second shift register being supplied, as the first clock signal of the first shift register, to the first shift register.

According to the invention, even if an abnormal pulse occurs in an input terminal of the second shift register due to a leak in the output switching element of the first shift register, so as to cause the input gate to turn on, the storage node is subjected to sink-down by the first switching element every time the second clock signal of the second shift register which corresponds to the first clock signal of the first shift register is active. This prevents a voltage of the storage node from rising and allows the storage node to be stable at a non-active voltage level (Low, VSS), so that the leak is not transmitted to following shift registers.

This brings about an effect of realizing a shift register circuit which is capable of preventing a malfunction even if a leak occurs in an output switching element of a shift register.

In order to attain the object, a shift register circuit of the present invention in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals, the each of the plurality of shift registers includes: an input gate from which an input signal is outputted only in a period in which the input signal is active; a storage node which is charged by the input signal supplied from the input gate; an output switching element, which has (i) a control terminal, connected to the storage node, via which the output switching element is turned on or off, (ii) one end terminal via which the first clock signal is inputted, and (iii) the other end terminal which is connected to an output terminal of the each of the plurality of shift registers; a first switching element connected between the storage node and a voltage supply which supplies a non-active voltage level to the storage node; and a control section which prepares a control signal and supplies the control signal to the control terminal of the first switching element, the control signal causing the first switching element to turn on in accordance with the non-active voltage level of the storage node and the voltage supply which supplies an active voltage level to the control terminal of the first switching element, the plurality of shift registers being connected to be cascaded such that in any first and second shift registers, between which shift pulse signals are communicated and in which the first shift register is followed by the second shift resister, an output terminal of the first shift register is connected to an input gate of the second shift register, and the second clock signal of the second shift register being supplied, as the first clock signal of the first shift register, to the first shift register.

According to the invention, even if an abnormal pulse occurs in an input terminal of the second shift register due to a leak in the output switching element of the first shift register, so as to cause the input gate to turn on, the storage node is subjected to sink-down by the first switching element every time the second clock signal of the second shift register which corresponds to the first clock signal of the first shift register is active. This prevents a voltage of the storage node from rising and allows the storage node to be stable at a non-active voltage level (Low, VSS), so that the leak is not transmitted to following shift registers.

This brings about an effect of realizing a shift register circuit which is capable of preventing a malfunction even if a leak occurs in an output switching element of a shift register.

In order to attain the object, the shift register circuit of the present invention is arranged such that: the control section includes a first control element which is a switching element of diode type and has an anode via which the second clock signal is supplied and a second control element which is a switching element and is connected between a cathode of the first control element and the voltage supply which supplies a non-active voltage level to the control terminal of the first switching element; and a node of the first control element and the second control element is connected to the control terminal of the first switching element.

According to the invention, since the storage node can be subjected to sink-down when the second clock signal is active, the storage node is not pulled up in response to a boost occurring in the output terminal of the first shift register due to a leaked current. This brings about an effect of preventing an occurrence of an abnormal pulse.

In order to attain the object, the shift register circuit of the present invention is arranged such that: the control section includes a first control element which is a capacitor and has one end via which the second clock signal is supplied and a second control element which is a switching element and is connected between the other end of the first control element and the voltage supply which supplies a non-active voltage level to the control terminal of the first switching element; and a node of the first control element and the second control element is connected to the control terminal of the first switching element.

According to the invention, since the capacitor is provided where a high voltage level at which the second clock signal is active is frequently applied, there occurs no change in characteristic (such as a shift of a threshold voltage) in the transistor. This brings about an effect of causing an increase in reliability of the whole circuit.

In order to attain the object, the shift register circuit of the present invention is arranged such that: the control section includes a first control element which is a switching element of diode type and has an anode which is connected to the voltage supply which supplies an active voltage level to the control terminal of the first switching element and a second control element which is a switching element and is connected between a cathode of the first control element and the voltage supply which supplies a non-active voltage level to the control terminal of the first switching element; and a node of the first control element and the second control element is connected to the control terminal of the first switching element.

According to the invention, the anode of the first control element is pulled up by the voltage supply which supplies an active voltage level to the control terminal of the first switching element. This brings about an effect of (i) causing the first switching element to turn on when the storage node is at a non-active voltage level and (ii) causing the first switching element to turn off when the storage node is at an active voltage level.

In order to attain the object, the shift register circuit of the present invention is arranged such that: the control section further includes a third control element which is a switching element and is connected between the control terminal of the first switching element and the voltage supply which supplies the non-active voltage level to the control terminal of the first switching element; and the third control element is controlled to turn on or off in accordance with the first clock signal.

According to the invention, in a period in which the control terminal of the first switching element is at a non-active voltage level, the third control element turns on every time the first clock signal is active, so as to subject the control terminal of the first switching element to sink-down. This prevents the control terminal of the first switching element from being floating in a period in which the first clock signal is at an active voltage level. This brings about an effect of allowing the control terminal of the first switching element to be stable at a non-active voltage level in the period in which the control terminal of the first switching element is at the non-active voltage level.

In a case where the first switching element is a transistor which is made of amorphous silicon, a phenomenon in which a threshold voltage shifts is more highly likely to occur since a larger DC bias voltage is applied to a gate as a period in which the transistor turns on is longer. The transistor may not operate due to such a phenomenon. However, it is possible to reduce a DC bias voltage to be applied to the control terminal of the first switching element by subjecting the control terminal of the first switching element to sink-down as described earlier. This brings about an effect of causing a further increase in reliability of the whole circuit.

In order to attain the object, the shift register circuit of the present invention is arranged such that: the control section further includes a fourth control element which is a switching element and is connected between an input terminal of the input gate and the voltage supply which supplies a non-active voltage level to the input gate; and a control terminal of the fourth control element via which the fourth control element is controlled to turn on or off is connected to the control terminal of the first switching element.

According to the invention, the output terminal of the first shift register can be subjected to sink-down every time the control terminal of the first switching element is at an active voltage level. Accordingly, the output terminal, which is subjected to sink-down, brings about an effect of causing the output terminal to be stable at a non-active voltage level in a period in which no output is carried out in each of the shift registers.

In order to attain the object, the shift register circuit of the present invention is arranged such that: the control section further includes a fourth control element which is a switching element and is connected between an input terminal of the input gate and the output terminal; and a control terminal of the fourth control element via which the fourth control element is controlled to turn on or off is connected to the control terminal of the first switching element.

According to the invention, the output terminal is subjected to sink-down by the second switching element when the second clock signal is active. This brings about an effect of subjecting the output terminal of the first shift register to sink-down through the fourth control terminal and the second switching element when the second clock signal is active.

In order to attain the object, the shift register circuit of the present invention is arranged such that the storage node and the output terminal are coupled to each other via a capacitor.

According to the invention, the capacitor via which the storage node and the output terminal are coupled to each other brings about a bootstrap effect. This brings about an effect of preventing a change in voltage level of the storage node even if a leak occurs in the output switching element.

In order to attain the object, the shift register circuit of the present invention is arranged such that: each of the plurality of shift registers further includes a third switching element which is connected between the storage node and the voltage supply which supplies a non-active voltage level to the storage node; and a control terminal of the third switching element via which the third switching element is controlled to turn on or off is connected to an output terminal of a shift register by which the each of the plurality of shift registers is followed.

The invention brings about an effect of causing an output from a shift register by which the each of the plurality of shift registers is followed to reset the storage node of the each of the plurality of shift registers to a non-active voltage level.

In order to attain the object, the shift register circuit of the present invention is arranged such that the shift operation is carried out by the whole plurality of shift registers in response to two-phase clock signals of the first clock signal and the second clock signal.

The invention brings about an effect of properly compensating for a leak in a conventional two-phase clock signal supply system.

In order to attain the object, the shift register circuit of the present invention is arranged such that the shift operation is carried out by the whole plurality of shift registers in response to three or more clock signals, whose phases are different from each other, including the first and second clock signals.

According to the invention, since the shift operation is carried out in response to three or more clock signals whose phases are different from each other, another operation can be carried out in a shift register in addition to the operation carried out in response to the first and second clock signals. This brings about an effect of allowing a shift register to operate with high accuracy.

In order to attain the object, the shift register circuit of the present invention is arranged such that the shift register circuit is made of amorphous silicon.

In a case where a transistor is used as a switching element in a shift register circuit which is made of amorphous silicon, the invention brings about an effect of stably carrying out sink-down by preventing a phenomenon in which a threshold voltage shifts.

In order to attain the object, the shift register circuit of the present invention is arranged such that the shift register circuit is made of microcrystalline silicon.

According to the invention, since sink-down is carried out in which a leak is compensated for in a shift register circuit which is made of microcrystalline silicon which causes a small variation in threshold voltage, a phenomenon in which a threshold voltage shifts due to sink-down can be more advantageously prevented than in the case of a shift register which is made of amorphous silicon. This brings about an effect of contributing to operation which is remarkably stably carried out by a transistor as designed.

In order to attain the object, the shift register circuit of the present invention is arranged such that the shift register circuit is made of polycrystalline silicon.

According to the invention, since sink-down is carried out in which a leak is compensated for in a shift register circuit which is made of polycrystalline silicon which is highly mobile but causes a large variation in threshold voltage, a margin for a malfunction in a transistor due to a leak can be increased as much as possible. This brings about an effect of contributing to a better use of an advantage of a high mobility.

In order to attain the object, a display device of the present invention uses, as a display driver, a shift register circuit mentioned above.

The invention brings about an effect of realizing a shift register circuit which is capable of preventing a malfunction even if a leak occurs in an output switching element of a shift register.

In order to attain the object, the display device of the present invention is arranged such that the shift register circuit is used as a scanning signal line driving circuit.

The invention brings about an effect of carrying out a favorable display due to an increase in reliability of operation carried out in a shift register circuit.

In order to attain the object, the display device of the present invention is arranged such that the shift register circuit is monolithically formed in a display region of a display panel.

The invention brings about an effect of causing a display device which is advantageous in structural simplification and in which a shift register circuit is monolithically formed in a display region of a display panel to carry out a favorable display by causing the shift register circuit to operate with higher reliability.

In order to attain the object, a method of the present invention for driving a shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals, the each of the plurality of shift registers including: an input gate from which an input signal is outputted only in a period in which the input signal is active; a storage node which is charged by the input signal supplied from the input gate; an output switching element, which has (i) a control terminal, connected to the storage node, via which the output switching element is turned on or off, (ii) one end terminal via which the first clock signal is inputted, and (iii) the other end terminal which is connected to an output terminal of the each of the plurality of shift registers; and a first switching element connected between the storage node and a voltage supply which supplies a non-active voltage level to the storage node, the plurality of shift registers being connected to be cascaded such that in any first and second shift registers, between which shift pulse signals are communicated and in which the first shift register is followed by the second shift resister, an output terminal of the first shift register is connected to an input gate of the second shift register, and the second clock signal of the second shift register being supplied, as the first clock signal of the first shift register, to the first shift register, the method includes the step of: preparing a control signal and supplying the control signal to the control terminal of the first switching element, the control signal causing the first switching element to turn on in accordance with the non-active voltage level of the storage node and an active voltage level of the second clock signal which active voltage level is obtained in a period in which the second clock signal is active.

According to the invention, even if an abnormal pulse occurs in an input terminal of the second shift register due to a leak in the output switching element of the first shift register, so as to cause the input gate to turn on, the storage node is subjected to sink-down by the first switching element every time the second clock signal of the second shift register which corresponds to the first clock signal of the first shift register is active. This prevents a voltage of the storage node from rising and allows the storage node to be stable at a non-active voltage level (Low, VSS), so that the leak is not transmitted to following shift registers.

This brings about an effect of realizing a method for driving a shift register circuit which is capable of preventing a malfunction even if a leak occurs in an output switching element of a shift register.

In order to attain the object, a method of the present invention for driving a shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals, the each of the plurality of shift registers including: an input gate from which an input signal is outputted only in a period in which the input signal is active; a storage node which is charged by the input signal supplied from the input gate; an output switching element, which has (i) a control terminal, connected to the storage node, via which the output switching element is turned on or off, (ii) one end terminal via which the first clock signal is inputted, and (iii) the other end terminal which is connected to an output terminal of the each of the plurality of shift registers; and a first switching element connected between the storage node and the output terminal, the plurality of shift registers being connected to be cascaded such that in any first and second shift registers, between which shift pulse signals are communicated and in which the first shift register is followed by the second shift resister, an output terminal of the first shift register is connected to an input gate of the second shift register, and the second clock signal of the second shift register being supplied, as the first clock signal of the first shift register, to the first shift register, the method includes the step of: preparing a control signal and supplying the control signal to the control terminal of the first switching element, the control signal causing the first switching element to turn on in accordance with the non-active voltage level of the storage node and an active voltage level of the second clock signal which active voltage level is obtained in a period in which the second clock signal is active.

According to the invention, even if an abnormal pulse occurs in an input terminal of the second shift register due to a leak in the output switching element of the first shift register, so as to cause the input gate to turn on, the storage node is subjected to sink-down by the first switching element every time the second clock signal of the second shift register which corresponds to the first clock signal of the first shift register is active. This prevents a voltage of the storage node from rising and allows the storage node to be stable at a non-active voltage level (Low, VSS), so that the leak is not transmitted to following shift registers.

This brings about an effect of realizing a method for driving shift register circuit which is capable of preventing a malfunction even if a leak occurs in an output switching element of a shift register.

In order to attain the object, a method of the present invention for driving a shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals, the each of the plurality of shift registers including: an input gate from which an input signal is outputted only in a period in which the input signal is active; a storage node which is charged by the input signal supplied from the input gate; an output switching element, which has (i) a control terminal, connected to the storage node, via which the output switching element is turned on or off, (ii) one end terminal via which the first clock signal is inputted, and (iii) the other end terminal which is connected to an output terminal of the each of the plurality of shift registers; and a first switching element connected between the storage node and a voltage supply which supplies a non-active voltage level to the storage node, the plurality of shift registers being connected to be cascaded such that in any first and second shift registers, between which shift pulse signals are communicated and in which the first shift register is followed by the second shift resister, an output terminal of the first shift register is connected to an input gate of the second shift register, and the second clock signal of the second shift register being supplied, as the first clock signal of the first shift register, to the first shift register, the method includes the step of: preparing a control signal and supplying the control signal to the control terminal of the first switching element, the control signal causing the first switching element to turn on in accordance with the non-active voltage level of the storage node and the voltage supply which supplies an active voltage level to the control terminal of the first switching element.

According to the invention, even if an abnormal pulse occurs in an input terminal of the second shift register due to a leak in the output switching element of the first shift register, so as to cause the input gate to turn on, the storage node is subjected to sink-down by the first switching element every time the second clock signal of the second shift register which corresponds to the first clock signal of the first shift register is active. This prevents a voltage of the storage node from rising and allows the storage node to be stable at a non-active voltage level (Low, VSS), so that the leak is not transmitted to following shift registers.

This brings about an effect of realizing a method for driving a shift register circuit which is capable of preventing a malfunction even if a leak occurs in an output switching element of a shift register.

### Advantageous Effects of Invention

As described earlier, a shift register circuit of the present invention in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals, the each of the plurality of shift registers includes: an input gate from which an input signal is outputted only in a period in which the input signal is active; a storage node which is charged by the input signal supplied from the input gate; an output switching element, which has (i) a control terminal, connected to the storage node, via which the output switching element is turned on or off, (ii) one end terminal via which the first clock signal is inputted, and (iii) the other end terminal which is connected to an output terminal of the each of the plurality of shift registers; a first switching element connected between the storage node and a voltage supply which supplies a non-active voltage level to the storage node; and a control section which prepares a control signal and supplies the control signal to the control terminal of the first switching element, the control signal causing the first switching element to turn on in accordance with the non-active voltage level of the storage node and an active voltage level of the second clock signal which active voltage level is obtained in a period in which the second clock signal is active, the plurality of shift registers being connected to be cascaded such that in any first and second shift registers, between which shift pulse signals are communicated and in which the first shift register is followed by the second shift resister, an output terminal of the first shift register is connected to an input gate of the second shift register, and the second clock signal of the second shift register being supplied, as the first clock signal of the first shift register, to the first shift register.

This brings about an effect of realizing a shift register circuit which is capable of preventing a malfunction even if a leak occurs in an output switching element of a shift register.

### Brief Description of Drawings

Fig. 1

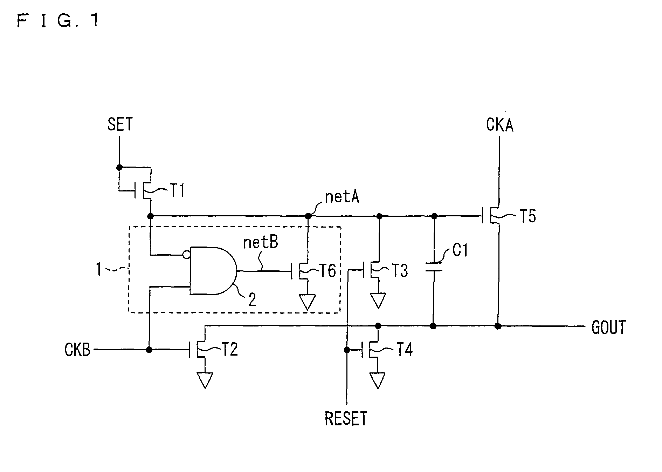

   Fig. 1, which shows an embodiment of the present invention, is a circuit diagram illustrating a configuration of each of shift registers of a shift register circuit.
Fig. 2

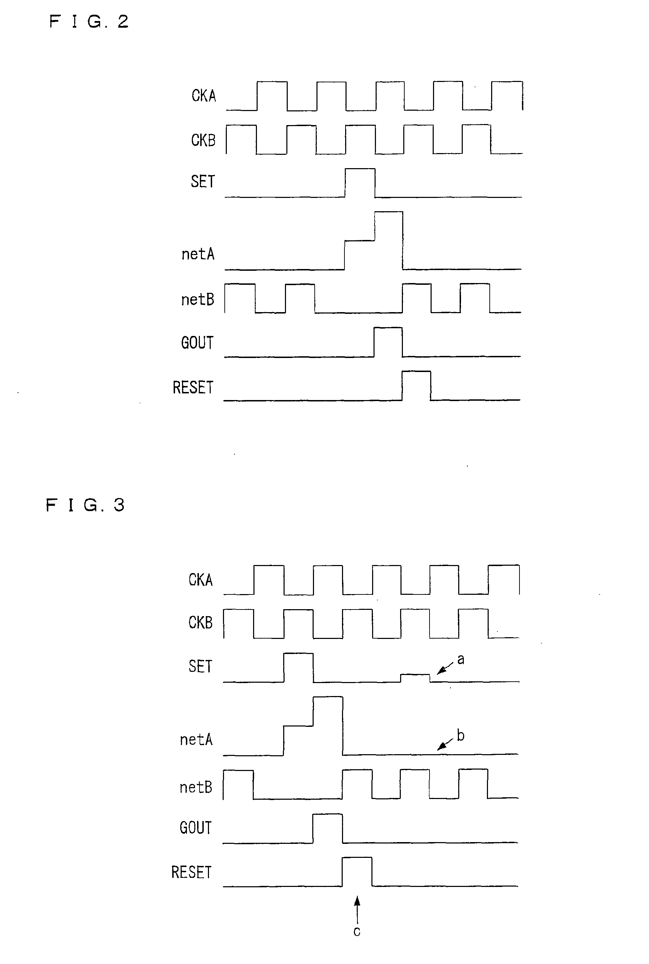

   Fig. 2 is a timing chart illustrating operation carried out in each of the shift registers of the configuration of Fig. 1.
Fig. 3
   Fig. 3 is a timing chart illustrating the operation carried out in each of the shift registers of the configuration of Fig. 1 when a leak occurs in an output switching element.
Fig. 4

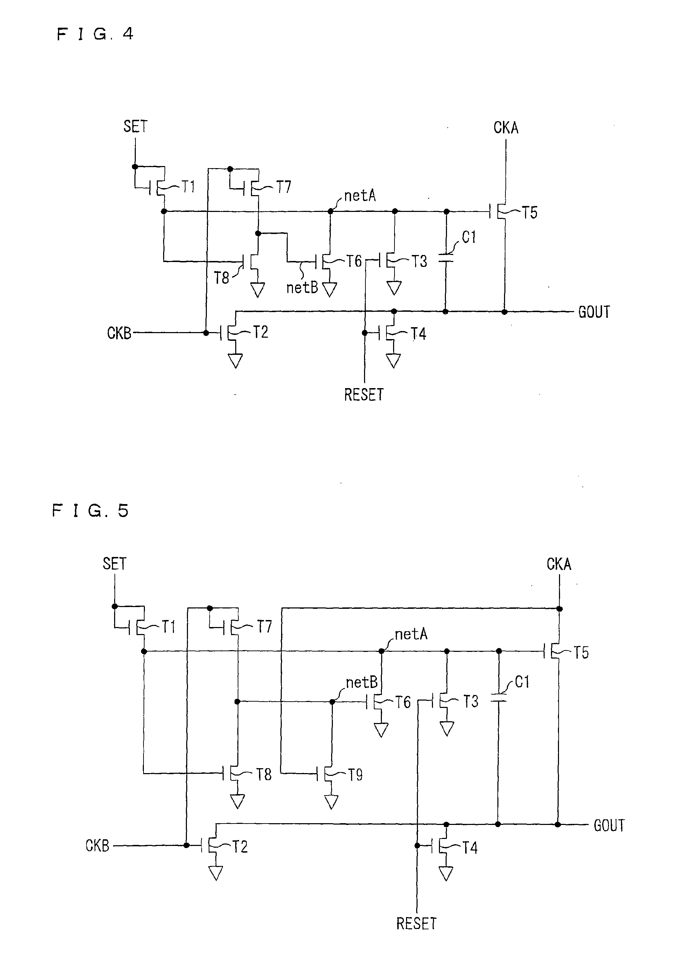

   Fig. 4 is a circuit diagram more specifically illustrating the configuration of Fig. 1.
Fig. 5
   Fig. 5 is a circuit diagram illustrating a configuration of a first modification of Fig. 4.
Fig. 6

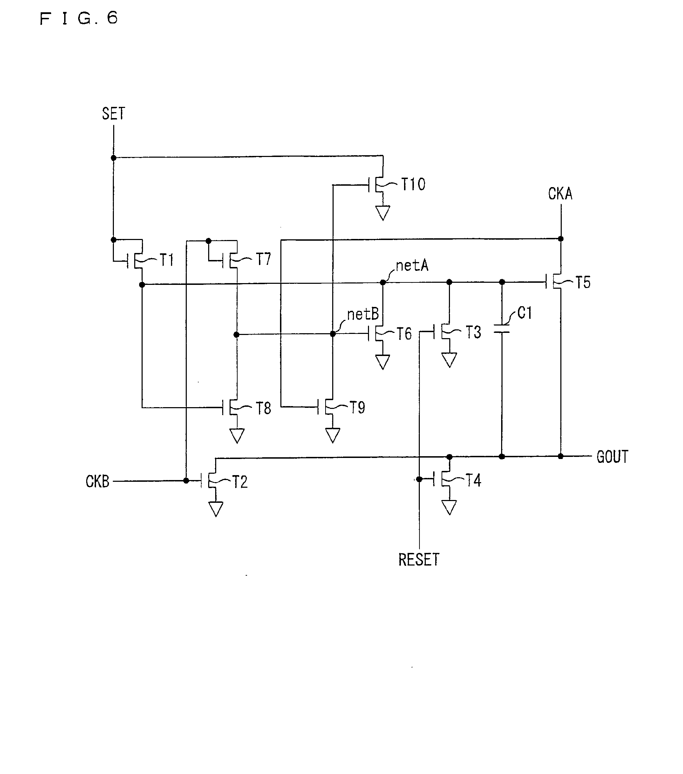

   Fig. 6 is a circuit diagram illustrating a configuration of a second modification of Fig. 4.
Fig. 7

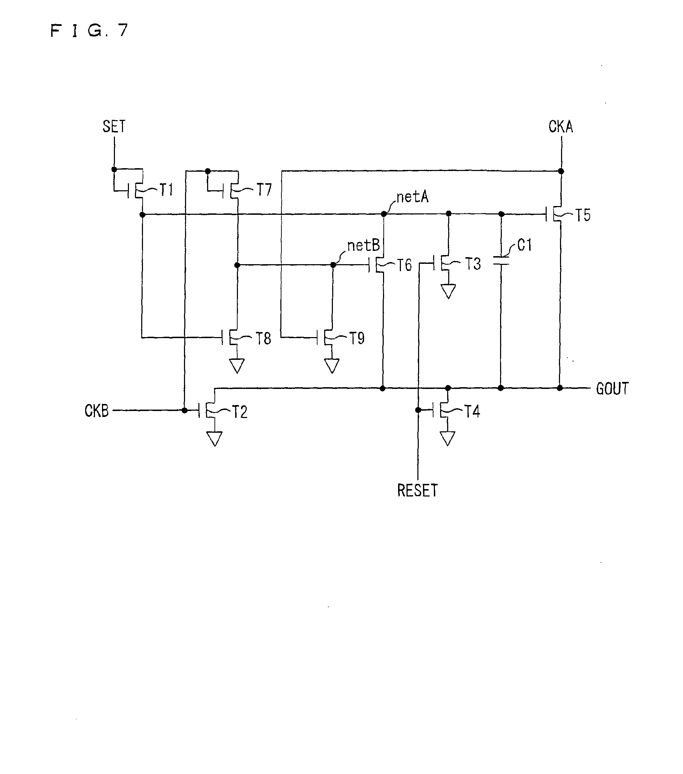

   Fig. 7 is a circuit diagram illustrating a configuration of a third modification of Fig. 4.
Fig. 8

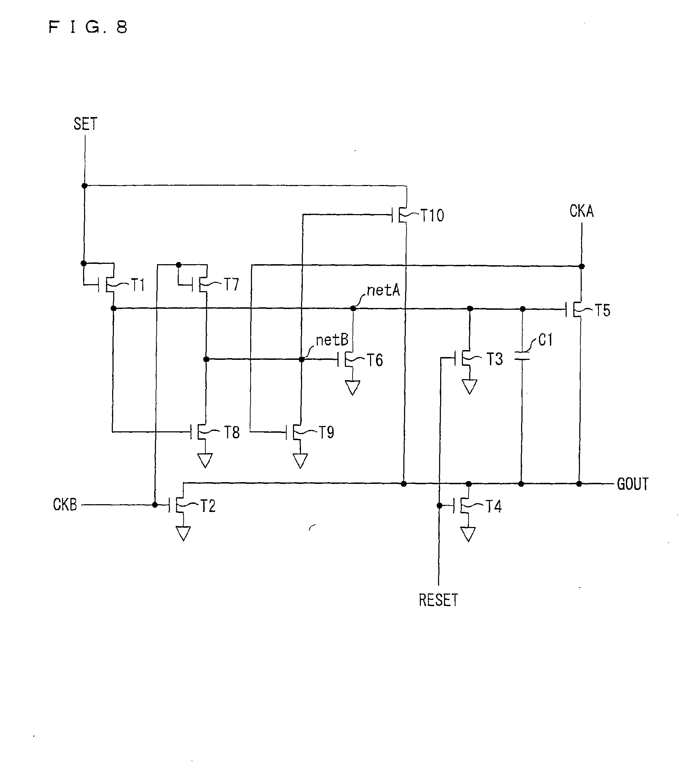

   Fig. 8 is a circuit diagram illustrating a configuration of a fourth modification of Fig. 4.
Fig. 9

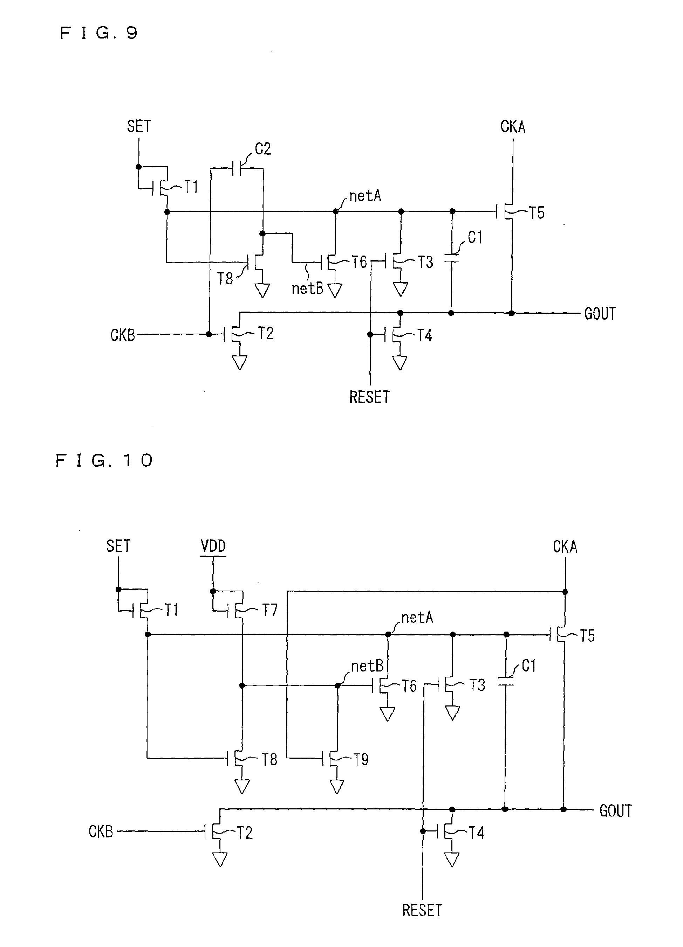

   Fig. 9 is a circuit diagram illustrating a configuration of a fifth modification of Fig. 4.
Fig. 10
   Fig. 10, which shows the embodiment of the present invention, is a circuit diagram illustrating another configuration of each of the shift registers of the shift register circuit.
Fig. 11

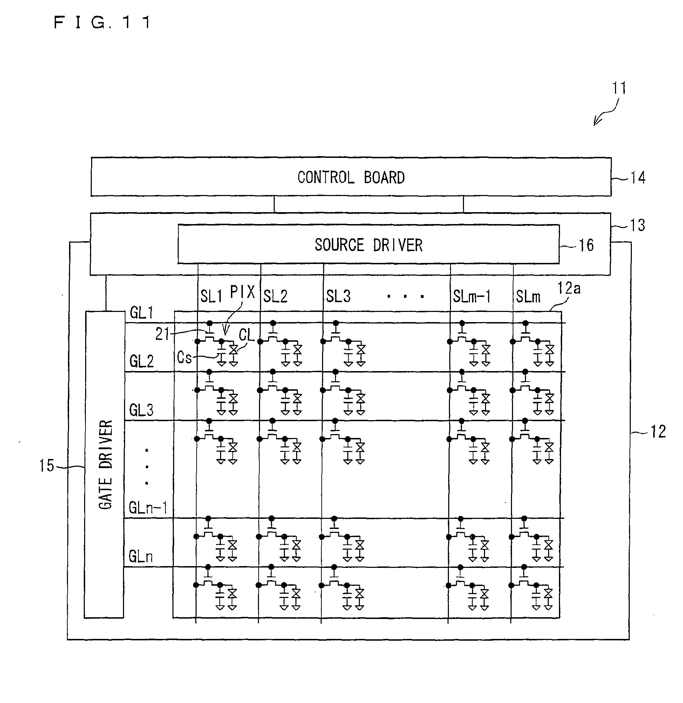

   Fig. 11, which shows the embodiment of the present invention, is a block diagram illustrating an arrangement of a display device.
Fig. 12
   Fig. 12, which shows prior art, is a block diagram illustrating a configuration of a shift register circuit.
Fig. 13
   Fig. 13 is a circuit diagram illustrating a configuration of each of shift registers of the shift register circuit of Fig. 12.
Fig. 14
   Fig. 14 is a timing chart illustrating operation carried out in each of the shift registers of Fig. 13.
Fig. 15
   Fig. 15 is a timing chart illustrating operation carried out in the shift register circuit of Fig. 12.
Fig. 16
   Fig. 16, which shows the prior art, is a block diagram illustrating another configuration of each of the shift registers of the shift register circuit.
Fig. 17
   Fig. 17, which shows the prior art, is a timing chart illustrating the operation carried out in the shift register circuit in response to an occurrence of a leak.

### Description of Embodiments

An embodiment of the present invention is described below with reference to Figs. 1 through 11.

Fig. 11 illustrates an arrangement of a liquid crystal display device 11 which is a display device in accordance with the present embodiment.

The liquid crystal display device 11 includes a display panel 12, a flexible printed-circuit board 13, and a control board 14.

The display panel 12 is an active matrix display panel including a glass substrate on which a display region 12a, a plurality of gate lines (scanning signal lines) GL..., a plurality of source lines (data signal lines) SL..., and a gate driver (scanning signal line driving circuit) 15 are formed by use of amorphous silicon. The display panel 12 can also be prepared by use of polycrystalline silicon, CG silicon, or microcrystalline silicon. The display region 12a is a region in which a plurality of picture elements PIX... are provided in a matrix manner. Each of the plurality of picture elements PIX... includes a TFT 21 selected by a corresponding picture element, a liquid crystal capacitor CL, and a storage capacitor Cs. A gate of the TFT 21 is connected to a corresponding gate line GL. A source of the TFT 21 is connected to a corresponding source line SL. A drain of the TFT 21 is connected to each of the liquid crystal capacitor CL and the storage capacitor Cs.

The plurality of gate lines GL..., which are GL1, GL2, GL3, ..., GLn (n: positive integer), are connected to respective outputs of the gate driver (scanning signal line driving circuit) 15. The plurality of source lines SL..., which are SL1, SL2, SL3, ..., SLm (m: positive integer), are connected to respective outputs of a source driver 16 (described later). Note that storage capacitor wirings (not illustrated) are provided for applying a storage capacitor voltage to the storage capacitor Cs of each of the picture elements PIX....

The gate driver 15, which is provided in a region of the display panel 12 which region is adjacent to the display region 12a and is located on one ends of the respective plurality of gate lines GL..., sequentially supplies gate pulse signals (scanning pulse signals) to the respective plurality of gate lines GL.... Further, another gate driver can also be provided in a region of the display panel 12 which region is adjacent to the display region 12a and is located on the other ends of the respective plurality of gate lines GL..., so as to cause the gate driver 15 and the another gate driver to scan different gate lines GL. These gate drivers and the display region 12a are monolithically formed on the display panel 12 by use of amorphous silicon or polycrystalline silicon. All monolithic gate drivers that are referred to as a monolithic gate driver, a gate driver-free, a built-in gate driver in panel, a gate in panel, etc can be used for the gate driver 15.

The flexible printed-circuit board 13 includes the source driver 16. The source driver 16 supplies data signals to the respective plurality of source lines SL.... The control board 14 is connected to the flexible printed-circuit board 13, so as to supply a necessary signal and a voltage to each of the gate driver 15 and the source driver 16. A signal and a voltage which have been supplied from the control board 14 so as to be supplied to the gate driver 15 are supplied via the flexible printed-circuit board 13 from the display panel 12 to the gate driver 15.

In order to monolithically form a gate driver as in the case of the gate driver 15, it is preferable to constitute all picture elements PIX... in one (1) line by identical picture elements, so as to cause the gate driver 15 to drive the plurality of gate lines GL... for each color of RGB. Since it is unnecessary to prepare the source driver 16 for each color in this case, it is possible to make the source driver 16 and the flexible printed-circuit board 13 smaller, which is advantageous.

The gate driver 15 can be configured such that shift registers are connected to be cascaded as in the case of the shift register circuit of Fig. 12. Namely, the shift registers are connected to be cascaded such that in any first and second shift registers, between which shift pulse signals are communicated and in which the first shift register is followed by the second shift register, an output terminal of the first shift register is connected to an input gate of the second shift register. A clock signal CK1, a clock signal CK2, a low supply voltage VSS, and a gate start pulse signal GSP which are similar to those described in Figs. 12 to 15 are usable. In particular, in any first and second shift registers, between which shift pulse signals are communicated, a second clock signal of the second shift register is supplied, as a first clock signal of the first shift register, to the first shift register.

Fig. 1 illustrates an arrangement of each of shift registers SRk (k: natural number) of a shift register circuit of the present embodiment.

According to the present embodiment, the clock signal CK1 and the clock signal CK2 serve as the first clock signal and the second clock signal, respectively in a shift register SRk (k: odd number), and the clock signal CK2 and the clock signal CK1 serve as the first clock signal and the second clock signal, respectively in a shift register SRk (k: even number). Namely, a clock signal inputted via a clock input terminal CKA and a clock signal inputted via a clock input terminal CKB serve as the first clock signal and the second clock signal, respectively. Shift operation is carried out by the whole shift register circuit in response to two-phase clock signals of the first clock signal and the second clock signal whose phases are different from each other.

Each of the shift registers SRk includes transistors T1, T2, T3, T4, and T5, a control section 1, and a capacitor C1. The transistor T5 is an output switching element, the transistor T1 is an input gate, the transistor T2 is a second switching element, a transistor T6 is a first switching element, the transistor T3 is a third switching element, and the transistor T4 is a fourth switching element. The control section 1 includes an AND circuit 2 and the transistor T6. The transistors used here are all n-channel TFTs. However, p-channel TFTs can be used or n-channel and p-channel TFTs can be used in combination. Note that each of the switching elements has a drain and a source which are one terminal and the other terminal, respectively of each of the switching elements and a gate which is a control terminal via which each of the switching elements is controlled to turn on or off. Note also that a field-effect transistor instead of a TFT can be used as each of the switching elements. A polarity and a type of a transistor and a kind of switching element which are described above are also applied to other configuration examples of the present embodiment.

The transistor T1 has a gate and a drain each of which is connected to a set terminal SET and a source which is connected to a gate of the transistor T5. The transistor T5, which is an output transistor in each of the shift registers SRk, has a drain which is connected to the clock input terminal CKA and a source which is connected to an output terminal GOUT. Namely, the transistor T5 is provided so as to transmit or so as not to transmit, to the output terminal GOUT, the clock signal inputted via the clock input terminal CKA. The capacitor C1is connected between the gate and the source of the transistor T5. A node whose voltage is equivalent to that of the gate of the transistor T5 is referred to as a node netA.

The transistor T3 has a gate which is connected to a reset terminal RESET, a drain which is connected to the node netA, and a source which is connected to a low supply voltage input terminal VSS. The transistor T4 has a gate which is connected to the reset terminal RESET, a drain which is connected to the output terminal GOUT, and a source which is connected to the low supply voltage input terminal VSS.

The transistor T2 has a gate which is connected to the clock input terminal CKB, a drain which is connected to the output terminal GOUT, and a source which is connected to the low supply voltage input terminal VSS.

The AND circuit 2 of the control section 1 is a 2-input gate circuit which has two input terminals, one of which is a low active terminal and the other of which is a high active terminal. The low active terminal is connected to the node netA and the high active terminal is connected to the clock input terminal CKB. The transistor T6 of the control section 1 has a gate which is connected to an output terminal of the AND circuit 2, a drain which is connected to the node netA, and a source which is connected to the low supply voltage input terminal VSS.

Next, operation of each of the shift registers SRk is to be described with reference to Figs. 2 and 3.

Before a shift pulse signal is inputted via the set terminal SET which is an input terminal of the input gate (transistor T1), each of the transistors T4 and T5 is in a high impedance state, the transistor T2 turns on every time a clock signal inputted via the clock input terminal CKB is at a high level, and the output terminal GOUT is at a low level. Note that in this period, the node netA which is a storage node is also at a low level. However, since a node netB which is an output of the AND gate 2 is at a high level in a period in which the clock signal inputted via the clock input terminal CKB is active (high), the transistor T6 turns on, so that the node netA is subjected to sink-down to the low supply voltage VSS. Note here that the low supply voltage VSS is a voltage supply which supplies a non-active voltage level to each of the gate of the transistor T5 and the output terminal GOUT.

After a gate pulse signal of the output signal GOUT of a shift register SRk-1 which gate pulse signal is the shift pulse signal is inputted via the set terminal SET, an output pulse signal is prepared in a shift register SRk and the transistor T1 turns on so as to charge the capacitor C1. The charge of the capacitor C1 raises the voltage of the node netA to (VGH - Vth) in a case where VGH represents a high level of the gate pulse signal and Vth represents a threshold voltage of the transistor T1. This causes the transistor T5 to turn on, so that the clock signal inputted via the clock input terminal CKA reaches the source of the transistor T5. The transistor T5 obtains a large overdrive voltage since a bootstrap effect of the capacitor C1 boosts the voltage of the node netA the moment a high level clock pulse signal is inputted via the clock input terminal CKA. This causes a high voltage level VGH of the inputted clock pulse signal to be transmitted to and outputted via the output terminal GOUT of the shift register SRk and consequently to be a gate pulse signal Gk (a pulse signal of the output signal GOUT).

When a voltage of the node netA which voltage is applied to the gate of the transistor T5 causes the transistor T5 to be active, the output of the AND circuit 2 is at a low level, so as to cause the transistor T6 to turn off.

An end of the input of the gate pulse signal via the set terminal SET causes the transistor T1 to turn off. In order to discharge an electric charge due to the node netA and the output terminal GOUT of a shift register SRk which are floating, a gate pulse signal Gk+1 of a shift register SRk+1 which gate pulse signal is inputted as a reset pulse signal via the reset terminal RESET causes each of the transistors T3 and T4 to turn on, so as to connect each of the node netA and the output terminal GOUT to the low supply voltage VSS. This causes the transistor T5 to turn off. An end of the input of the reset pulse signal ends the period in which the output pulse signal is prepared in the shift register SRk. The period is followed by a period in which the output terminal GOUT is at a low level again.

In the period in which the output terminal GOUT is at the low level, the output of the AND circuit 2 is at a high level in the period in which the clock signal inputted via the clock input terminal CKB is active, so as to cause the transistor T6 to turn on. This subjects the node netA to sink-down.

The control section 1 operates as described earlier. Therefore, even if the clock signal inputted via the clock input terminal CKA is active (high) and then leaks into the output terminal GOUT (see a of Fig. 3) due to a leak in the transistor T5 after the node netA is reset by a reset pulse signal at c of Fig. 3, the node netA is subjected to sink-down every time the clock signal which is inputted via the clock input terminal CKB and corresponds to the clock signal inputted via the clock input terminal CKA of a shift register SRk-1 is active (high). This prevents a voltage of the node netA from rising and allows the node netA to be stable at a non-active voltage level (Low, VSS) (see b of Fig. 3), so that the leak is not transmitted to following shift registers.

As described earlier, it is possible to realize a shift register circuit which is capable of preventing a malfunction even if a leak occurs in an output switching element of a shift register, a display device including the shift register circuit, and a method for driving the shift register circuit.

Note that such prevention of a malfunction due to a leak can be carried out without the need of supplying a special signal other than a signal used for shift operation of a shift register circuit.

Next, Fig. 4 more specifically illustrates the configuration of the control section 1.

Fig. 4 illustrates an example of the AND circuit 2 which is constituted by transistors T7 and T8. The transistors T7 and T8 are a first control element and a second control element, respectively. The transistor T7, which has a gate and a drain each of which is connected to the clock input terminal CKB, functions as a switching element of diode type which has a gate and a drain each of which is an anode and a source which is a cathode. The transistor T8 has a gate which is connected to the node netA, a drain which is connected to a source of the transistor T7, and a source which is connected to the low supply voltage input terminal VSS. The transistor T7 and the transistor T8 are connected via the output terminal of the AND circuit 2, i.e., the node netB to a gate of the transistor T6.

The transistor T7, which is diode-connected, pulls up the node netB to an active high voltage level when the clock signal inputted via the clock input terminal CKB is active (high). When the node netA is at an active high voltage level, the transistor T8 masks the transistor T6 by pulling down the node netB to a non-active low voltage level, so as not to cause the transistor T6 to turn on.

Since it is possible to cause the transistors T7 and T8 to subject the node netA to sink-down when the clock input terminal CKB is at an active high voltage level, the node netA is not pulled up in response to a boost occurring in the output terminal GOUT of a shift register SRk-1 due to a leaked current. This can prevent an occurrence of an abnormal pulse.

Next, Fig. 5 illustrates a configuration of a first modification of the control section 1.

A control section 1 of Fig. 5 is obtained by adding a transistor T9 to the control section 1 of Fig. 4. The transistor T9 is a third control element. The transistor T9 has a gate which is connected to the clock input terminal CKA, a drain which is connected to the node netA, and a source which is connected to the low supply voltage input terminal VSS.

According to this, in a period in which the node netB is at a non-active voltage level (Low, VSS), the transistor T9 turns on every time the clock signal inputted via the clock input terminal CKA is active, so that the node netB is subjected to sink-down. This prevents the node netB from being floating in a period in which the clock input terminal CKA has a high voltage level at which the clock signal is active. This allows the node netB to be stable at the non-active voltage level (Low, VSS) in the period in which the node netB is at the non-active voltage level (Low, VSS).

In a case where a transistor is made of amorphous silicon, a phenomenon in which a threshold voltage Vth shifts is more highly likely to occur since a larger DC bias voltage is applied to a gate as a period in which the transistor turns on is longer. The transistor may not operate due to such a phenomenon. However, it is possible to reduce a DC bias voltage to be applied to the gate of the transistor T6 by subjecting the node netB to sink-down as described earlier. This can cause a further increase in reliability of the whole circuit.

Next, Fig. 6 illustrates a configuration of a second modification of the control section 1.

A control section 1 of Fig. 6 is obtained by adding a transistor T10 to the control section 1 of Fig. 5. The transistor T10 is a fourth control element. The transistor T10 has a gate which is connected to the node netB, a drain which is connected to the set terminal SET, and a source which is connected to the low supply voltage input terminal VSS.

This can subject the output terminal GOUT of a shift register SRk-1 to sink-down every time the node netB is at an active high voltage level. The output terminal GOUT, which is subjected to sink-down, can be stable at a non-active voltage level in a period in which no gate output is carried out in each of the shift registers.

Next, Fig. 7 illustrates a configuration of a third modification of the control section 1.

A control section 1 of Fig. 7 is obtained by connecting the source of the transistor T6 of the control section 1 of Fig. 5 to the output terminal GOUT instead of the low supply voltage input terminal VSS. According to this, the output terminal GOUT is subjected to sink-down by the transistor T2 when the clock signal inputted via the clock input terminal CKB is active (high). This subjects the node netA to sink-down when the clock signal inputted via the clock input terminal CKB through the transistor T6 and the transistor T2 is active (high). This allows obtainment of an effect similar to that obtained from the configuration of Fig. 5.

The control section 1 of Fig. 7, which is realized by connecting the source of the transistor T6 to the clock input terminal CKA instead of the output terminal GOUT, also allows obtainment of an effect similar to that obtained from the configuration of Fig. 5 since the clock signal inputted via the clock input terminal CKA is non-active (low, VSS) when the clock signal inputted via the clock input terminal CKB is active (high).

Next, Fig. 8 illustrates a configuration of a fourth modification of the control section 1.

A control section 1 of Fig. 8 is obtained by connecting the source of the transistor T10 of the control section 1 of Fig. 6 to the output terminal GOUT instead of the low supply voltage input terminal VSS. According to this, the output terminal GOUT is subjected to sink-down by the transistor T2 when the clock signal inputted via the clock input terminal CKB is active (high). This subjects the output terminal GOUT of a shift register Sk-1 to sink-down when the clock signal inputted via the clock input terminal CKB through the transistor T10 and the transistor T2 is active (high). This allows obtainment of an effect similar to that obtained from the configuration of Fig. 6.

The control section 1 of Fig. 7, which is realized by connecting the source of the transistor T6 to the clock input terminal CKA instead of the output terminal GOUT, also allows obtainment of an effect similar to that obtained from the configuration of Fig. 5 since the clock signal inputted via the clock input terminal CKA is non-active (low, VSS) when the clock signal inputted via the clock input terminal CKB is active (high).

Next, Fig. 9 illustrates a configuration of a fifth modification of the control section 1.

A control section 1 of Fig. 9 is obtained by connecting, as the first control element, a capacitor C2 instead of the transistor T7 of Fig. 4 between the clock input terminal CKB and the transistor T8 in the control section 1 of Fig. 4.

According to this, since the node netB and the clock input terminal CKB are coupled to each other via a capacitor C2, it is possible to cause the node netB to be at an active high voltage level in a case where the node netA is at a non-active low voltage level and the clock signal inputted via the clock input terminal CKB is active (high) and to cause the node netB to be at a non-active low voltage level in a case where the node netA is at an active high voltage level and the clock signal inputted via the clock input terminal CKB is non-active (low).

In this case, there occurs no change in characteristic (such as a shift of a threshold voltage) in the transistor, so as to cause an increase in reliability of the whole circuit. This is because differently from the configuration of Fig. 4, the capacitor C2 is provided where a high voltage level at which the clock signal inputted via the clock input terminal CKB is active is frequently applied.

Next, Fig. 10 illustrates a configuration of another control section of the present embodiment.

The control section of Fig. 10 is obtained by causing the gate and the drain of the transistor T7 of the control section 1 of Fig. 5 to be connected to a high voltage supply VDD instead of the clock input terminal CKB. The high voltage supply VDD is a voltage supply which supplies an active high voltage level to the node netB, i.e., the gate of the transistor T6.

According to this, the gate and the drain of the transistor T7, each of which is pulled up by the high voltage supply VDD, cause the node netB to be at an active high voltage level when the node netA is at a non-active low voltage level and cause the node netB to be at a non-active low voltage level when the node netA is at an active high voltage level. This allows obtainment of an effect similar to those obtained from the configurations of Figs. 4 and 5. Note that, since the node netB is subjected to sink-down by the transistor T9 when the clock signal inputted via the clock input terminal CKA is active (high), it is possible to cause a change in voltage of the node netB as in the case of Fig. 4.

Note that in each of the above configurations, it is possible to freely decide (i) which of the transistors T9 and T10 is to be used, (ii) to where the sources of respective of the transistors T6 and T10 are connected, (iii) which of the transistor T7 and the capacitor C2 is to be used, (iv) to where the gate and the drain of the transistor T7 are connected, etc.

Note also the shift operation can be carried out by the whole shift registers in response to three or more clock signals, whose phases are different from each other, including the first and second clock signals, generally in response to two or more clock signals whose phases are different from each other. In the case of three or more clock signals whose phases are different from each other, another operation can be carried out in a shift register in addition to the operation carried out in response to the first and second clock signals. In the case of two-phase clock signals described earlier, it is possible to properly compensate for a leak in a conventional clock signal supply system.

The above description discusses the present embodiment. The present invention is applicable to other display devices such as an EL display device in each of which a shift register circuit is used.

The invention is not limited to the description of the embodiments above, but may be altered within the scope of the claims. An embodiment based on a proper combination of technical means disclosed in different embodiments is encompassed in the technical scope of the invention.

### Industrial Applicability

The present invention is suitably usable especially for display devices such as a liquid crystal display device and an EL display device.

### Reference Signs List

- 1: Control section
- 2: AND circuit
- 11: Liquid crystal display device (Display device)
- 15 circuit): Gate driver (Scanning signal line driving
- SR: Shift Register
- CK1, CK2 clock signal): Clock signal (First clock signal, Second
- netA: Node (Storage node)
- GOUT: Output terminal
- T1 diode type): Transistor (Input gate, Switching element of
- T2: Transistor (Second switching element)
- T5: Transistor (Output switching element)
- T6: Transistor (First switching element)

## Claims

1. A shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals,
said each of the plurality of shift registers comprising:
an input gate from which an input signal is outputted only in a period in which the input signal is active;
a storage node which is charged by the input signal supplied from the input gate;
an output switching element, which has (i) a control terminal, connected to the storage node, via which the output switching element is turned on or off, (ii) one end terminal via which the first clock signal is inputted, and (iii) the other end terminal which is connected to an output terminal of said each of the plurality of shift registers;
a first switching element connected between the storage node and a voltage supply which supplies a non-active voltage level to the storage node; and
a control section which prepares a control signal and supplies the control signal to the control terminal of the first switching element, the control signal causing the first switching element to turn on in accordance with the non-active voltage level of the storage node and an active voltage level of the second clock signal which active voltage level is obtained in a period in which the second clock signal is active,
the plurality of shift registers being connected to be cascaded such that in any first and second shift registers, between which shift pulse signals are communicated and in which the first shift register is followed by the second shift resister, an output terminal of the first shift register is connected to an input gate of the second shift register, and
the second clock signal of the second shift register being supplied, as the first clock signal of the first shift register, to the first shift register.

2. A shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals,
said each of the plurality of shift registers comprising:
an input gate from which an input signal is outputted only in a period in which the input signal is active;
a storage node which is charged by the input signal supplied from the input gate;
an output switching element, which has (i) a control terminal, connected to the storage node, via which the output switching element is turned on or off, (ii) one end terminal via which the first clock signal is inputted, and (iii) the other end terminal which is connected to an output terminal of said each of the plurality of shift registers;
a first switching element connected between the storage node and the output terminal; and
a control section which prepares a control signal and supplies the control signal to the control terminal of the first switching element, the control signal causing the first switching element to turn on in accordance with the non-active voltage level of the storage node and an active voltage level of the second clock signal which active voltage level is obtained in a period in which the second clock signal is active,
the plurality of shift registers being connected to be cascaded such that in any first and second shift registers, between which shift pulse signals are communicated and in which the first shift register is followed by the second shift resister, an output terminal of the first shift register is connected to an input gate of the second shift register, and
the second clock signal of the second shift register being supplied, as the first clock signal of the first shift register, to the first shift register.

3. A shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals,
said each of the plurality of shift registers comprising:
an input gate from which an input signal is outputted only in a period in which the input signal is active;
a storage node which is charged by the input signal supplied from the input gate;
an output switching element, which has (i) a control terminal, connected to the storage node, via which the output switching element is turned on or off, (ii) one end terminal via which the first clock signal is inputted, and (iii) the other end terminal which is connected to an output terminal of said each of the plurality of shift registers;
a first switching element connected between the storage node and a voltage supply which supplies a non-active voltage level to the storage node; and
a control section which prepares a control signal and supplies the control signal to the control terminal of the first switching element, the control signal causing the first switching element to turn on in accordance with the non-active voltage level of the storage node and the voltage supply which supplies an active voltage level to the control terminal of the first switching element,
the plurality of shift registers being connected to be cascaded such that in any first and second shift registers, between which shift pulse signals are communicated and in which the first shift register is followed by the second shift resister, an output terminal of the first shift register is connected to an input gate of the second shift register, and
the second clock signal of the second shift register being supplied, as the first clock signal of the first shift register, to the first shift register.

4. The shift register circuit as set forth in claim 1 or 2, wherein:
the control section includes a first control element which is a switching element of diode type and has an anode via which the second clock signal is supplied and a second control element which is a switching element and is connected between a cathode of the first control element and the voltage supply which supplies a non-active voltage level to the control terminal of the first switching element; and
a node of the first control element and the second control element is connected to the control terminal of the first switching element.

5. The shift register circuit as set forth in claim 1 or 2, wherein:
the control section includes a first control element which is a capacitor and has one end via which the second clock signal is supplied and a second control element which is a switching element and is connected between the other end of the first control element and the voltage supply which supplies a non-active voltage level to the control terminal of the first switching element; and
a node of the first control element and the second control element is connected to the control terminal of the first switching element.

6. The shift register circuit as set forth in claim 3, wherein:
the control section includes a first control element which is a switching element of diode type and has an anode which is connected to the voltage supply which supplies an active voltage level to the control terminal of the first switching element and a second control element which is a switching element and is connected between a cathode of the first control element and the voltage supply which supplies a non-active voltage level to the control terminal of the first switching element; and
a node of the first control element and the second control element is connected to the control terminal of the first switching element.

7. The shift register circuit as set forth in any one of claims 4 through 6, wherein:
the control section further includes a third control element which is a switching element and is connected between the control terminal of the first switching element and the voltage supply which supplies the non-active voltage level to the control terminal of the first switching element; and
the third control element is controlled to turn on or off in accordance with the first clock signal.

8. The shift register circuit as set forth in any one of claims 4 through 7, wherein:
the control section further includes a fourth control element which is a switching element and is connected between an input terminal of the input gate and the voltage supply which supplies a non-active voltage level to the input gate; and
a control terminal of the fourth control element via which the fourth control element is controlled to turn on or off is connected to the control terminal of the first switching element.

9. The shift register circuit as set forth in any one of claims 4 through 7, wherein:
the control section further includes a fourth control element which is a switching element and is connected between an input terminal of the input gate and the output terminal; and
a control terminal of the fourth control element via which the fourth control element is controlled to turn on or off is connected to the control terminal of the first switching element.

10. The shift register circuit as set forth in any one of claims 1 through 9, wherein the storage node and the output terminal are coupled to each other via a capacitor.

11. The shift register circuit as set forth in any one of claims 1 through 10, wherein:
each of the plurality of shift registers further includes a second switching element which is connected between the output terminal and the voltage supply which supplies a non-active voltage level to the output terminal; and
the second switching element is controlled to turn on or off in accordance with the second clock signal.

12. The shift register circuit as set forth in any one of claims 1 through 11, wherein:
each of the plurality of shift registers further includes a third switching element which is connected between the storage node and the voltage supply which supplies a non-active voltage level to the storage node; and
a control terminal of the third switching element via which the third switching element is controlled to turn on or off is connected to an output terminal of a shift register by which said each of the plurality of shift registers is followed.

13. The shift register circuit as set forth in any one of claims 1 through 12, wherein:
each of the plurality of shift registers further includes a fourth switching element which is connected between the output terminal and the voltage supply which supplies a non-active voltage level to the output terminal; and
a control terminal of the fourth switching element via which the fourth switching element is controlled to turn on or off is connected to an output terminal of a shift register by which said each of the plurality of shift registers is followed.

14. The shift register circuit as set forth in any one of claims 1 through 13, wherein the shift operation is carried out by the whole plurality of shift registers in response to two-phase clock signals of the first clock signal and the second clock signal.

15. The shift register circuit as set forth in any one of claims 1 through 13, wherein the shift operation is carried out by the whole plurality of shift registers in response to three or more clock signals, whose phases are different from each other, including the first and second clock signals.

16. The shift register circuit as set forth in any one of claims 1 through 15, wherein the shift register circuit is made of amorphous silicon.

17. The shift register circuit as set forth in any one of claims 1 through 15, wherein the shift register circuit is made of microcrystalline silicon.

18. The shift register circuit as set forth in any one of claims 1 through 15, wherein the shift register circuit is made of polycrystalline silicon.

19. A display device in which a shift register circuit recited in any one of claims 1 through 18 is used as a display driver.

20. The display device as set forth in claim 19, wherein the shift register circuit is used as a scanning signal line driving circuit.

21. The display device as set forth in claim 19 or 20, wherein the shift register circuit is monolithically formed in a display region of a display panel.

22. A method for driving a shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals,
said each of the plurality of shift registers comprising:
an input gate from which an input signal is outputted only in a period in which the input signal is active;
a storage node which is charged by the input signal supplied from the input gate;
an output switching element, which has (i) a control terminal, connected to the storage node, via which the output switching element is turned on or off, (ii) one end terminal via which the first clock signal is inputted, and (iii) the other end terminal which is connected to an output terminal of said each of the plurality of shift registers; and
a first switching element connected between the storage node and a voltage supply which supplies a non-active voltage level to the storage node,
the plurality of shift registers being connected to be cascaded such that in any first and second shift registers, between which shift pulse signals are communicated and in which the first shift register is followed by the second shift resister, an output terminal of the first shift register is connected to an input gate of the second shift register, and
the second clock signal of the second shift register being supplied, as the first clock signal of the first shift register, to the first shift register,
said method comprising the step of:
preparing a control signal and supplying the control signal to the control terminal of the first switching element, the control signal causing the first switching element to turn on in accordance with the non-active voltage level of the storage node and an active voltage level of the second clock signal which active voltage level is obtained in a period in which the second clock signal is active.

23. A method for driving a shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals,
said each of the plurality of shift registers comprising:
an input gate from which an input signal is outputted only in a period in which the input signal is active;
a storage node which is charged by the input signal supplied from the input gate;
an output switching element, which has (i) a control terminal, connected to the storage node, via which the output switching element is turned on or off, (ii) one end terminal via which the first clock signal is inputted, and (iii) the other end terminal which is connected to an output terminal of said each of the plurality of shift registers; and
a first switching element connected between the storage node and the output terminal,
the plurality of shift registers being connected to be cascaded such that in any first and second shift registers, between which shift pulse signals are communicated and in which the first shift register is followed by the second shift resister, an output terminal of the first shift register is connected to an input gate of the second shift register, and
the second clock signal of the second shift register being supplied, as the first clock signal of the first shift register, to the first shift register,
said method comprising the step of:
preparing a control signal and supplying the control signal to the control terminal of the first switching element, the control signal causing the first switching element to turn on in accordance with the non-active voltage level of the storage node and an active voltage level of the second clock signal which active voltage level is obtained in a period in which the second clock signal is active.

24. A method for driving a shift register circuit in which a plurality of shift registers are included, first and second clock signals whose phases are different from each other are supplied to each of the plurality of shift registers, and shift operation is carried out by the whole plurality of shift registers in response to two or more clock signals, whose phases are different from each other, including the first and second clock signals,
said each of the plurality of shift registers comprising:
an input gate from which an input signal is outputted only in a period in which the input signal is active;
a storage node which is charged by the input signal supplied from the input gate;
an output switching element, which has (i) a control terminal, connected to the storage node, via which the output switching element is turned on or off, (ii) one end terminal via which the first clock signal is inputted, and (iii) the other end terminal which is connected to an output terminal of said each of the plurality of shift registers; and
a first switching element connected between the storage node and a voltage supply which supplies a non-active voltage level to the storage node,
the plurality of shift registers being connected to be cascaded such that in any first and second shift registers, between which shift pulse signals are communicated and in which the first shift register is followed by the second shift resister, an output terminal of the first shift register is connected to an input gate of the second shift register, and
the second clock signal of the second shift register being supplied, as the first clock signal of the first shift register, to the first shift register,
said method comprising the step of:
preparing a control signal and supplying the control signal to the control terminal of the first switching element, the control signal causing the first switching element to turn on in accordance with the non-active voltage level of the storage node and the voltage supply which supplies an active voltage level to the control terminal of the first switching element.
